# EUROPEAN PATENT SPECIFICATION

(11) **EP 2 860 536 B1**
(45) Date of publication and mention of the grant of the patent: **05.12.2018**
(21) Application number: 14187605.2
(22) Date of filing: 03.10.2014
(51) Int. Cl.: G01R 31/00, G01R 31/12, G01R 31/14, G01R 29/12, G01J 1/44, H02H 9/02

(54) **Integrated corona fault detection**
Integrierte Koronafehlererkennung
Détection de défaillance de Corona intégré

(30) Priority: 09.10.2013 US 201361888897 P; 25.02.2014 US 201414189329
(43) Date of publication of application: 15.04.2015
(73) Proprietor: Hamilton Sundstrand Corporation, Windsor Locks, CT 06096-1010 (US)
(72) Inventor: Horowy, John, Rockford, Illinois 61114 (US); Galloway, Gary L., Rockford, Illinois 61114 (US); Said, Waleed M., Rockford, Illinois 61114 (US); Pal, Debabrata, Hoffman Estate, Illinois 60195 (US)
(74) Representative: Dehns

(56) References cited:
- EP-A1- 2 461 449
- WO-A1-96/35128
- WO-A1-2012/059335
- KR-B1- 101 232 750
- US-A1- 2006 209 632
- US-A1- 2010 072 355
- BLOKHINTSEV I ET AL: "Hot-spot huning - Experience with online partial discharge analysis as a tool for predictive maintenance for medium-voltage switchgear systems", IEEE INDUSTRY APPLICATIONS MAGAZINE, IEEE SERVICE CENTER, PISCATAWAY, NJ, US, vol. 10, no. 5, 1 September 2004 (2004-09-01), pages 41-47, XP011118490, ISSN: 1077-2618, DOI: 10.1109/MIA.2004.1330769
- AZCARRAGA C G ET AL: "Experiences on GIS On-Site Evaluation Using High Sensitivity PD Techniques", POWER ENGINEERING, 2007 LARGE ENGINEERING SYSTEMS CONFERENCE ON, IEEE, PI, 1 October 2007 (2007-10-01), pages 182-186, XP031206832, DOI: 10.1109/LESCPE.2007.4437375 ISBN: 978-1-4244-1582-3
- THOMAS W DAKIN ET AL: "Corona Measurement and Interpretation", IEEE TRANSACTIONS ON POWER APPARATUS AND SYSTEMS, IEEE INC. NEW YORK, US, vol. 71, no. 3, 1 April 1957 (1957-04-01), pages 1059-1065, XP011209592, ISSN: 0018-9510

## Description

### BACKGROUND

The present invention relates to fault protection and in particular to detection of corona events. Electrical boxes are used in a variety of applications to enclose electrical components. In some cases, voltages associated with the electrical components within a box may generate a corona event. Corona events are a well-known phenomenon in which ions form in a fluid (such as air) between two components of different voltages. In a corona event, the electric field around an object is high enough to form a conductive region, but not high enough to cause electrical breakdown or arcing to nearby objects.

If unchecked, the electric field may eventually result in electrical breakdown (i.e., an arc fault) arcing. Such arcing can be destructive to electronic components. In the context of an electrical box, arcing presents hazards including damage to the arcing component, damage to adjacent components, and fire hazard.

A power distribution cabinet having the features of the preamble of claim 1 is disclosed in US 2006/209632 A1.

WO 96/35128 A1 discloses a method a method for monitoring partial discharges in a transformer. Capacitive and inductive sensors are used to sense the fields generated within the transformer. The output of the sensors is filtered and analyzed to detect discharges within the transformer.

WO 2012/059335 A1 discloses a partial discharge sensor that includes a housing and a measurement circuit. The sensor connects to a high voltage line in order to monitor for partial discharges.

EP 2461449 A1 discloses an arc fault detection system that includes several controllers and a sensor. The system is utilized to sense arc faults by utilizing the sensor to detect ultraviolet light within the electrical system.

US 2010/072355 A1 discloses a system that is capable of providing a self-test of arc fault detection. The system periodically transmits electro-optical (EO) radiation through transmission cables. A sensor of the system is utilized to detect the transmitted EO radiation and detect a fault. The system is capable of distinguishing between test radiation and the radiation caused by actual arc faults.

### SUMMARY

The present invention provides a power distribution cabinet as set forth in claim 1 as well as a method of preventing electrical discharge as set forth in claim 7. Advantageous embodiments are described in the dependent claims.

### BRIEF DESCRIPTION OF THE DRAWINGS

Fig. 1 is a cross-sectional plan view of a fault detection system employed in an electrical box.
Fig. 2 is a flowchart illustrating operation of the fault detection system.

### DETAILED DESCRIPTION

A corona detection system is described that allows for the detection of corona events within an electrical box. Capacitive sensors are located along interior walls of the electrical box, and provide an output indicative of displacement current in a region adjacent to the sensor that can be used to detect corona events. Remedial actions can then be taken in response to the detected corona event to prevent more serious arc fault events. Maximum functionality of the electronic components housed in the box is maintained by a controller that is capable of determining which zone the corona event (or arcing) occurred in, and maintaining power to electronic components in other zones while powering down potentially hazardous components.

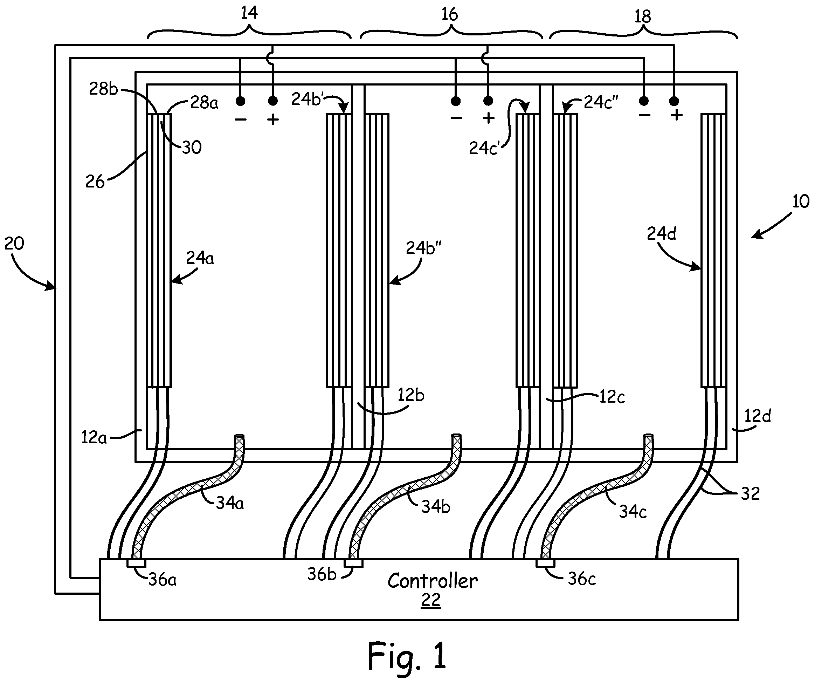

Fig. 1 is a cross-sectional plan view of electrical box 10 having three distinct zones. In the embodiment shown in Fig. 1, box 10 is a power distribution cabinet that includes walls 12 that divide box 10 into first zone 14, second zone 16, and third zone 18. Each of the zones 14, 16, and 18 include power components that are supplied with power via power supply bus 20. Controller 22 controls the allocation and distribution of power from power supply bus 20 to each of the zones 14, 16, and 18. Within each of the zones are capacitive sensors 24. In the embodiment shown in Fig. 1, first zone 14 contains capacitive sensor 24a arranged on wall 12a, as well as capacitive sensor 24b' arranged on wall 12b. Second zone 16 contains capacitive sensor 24b" arranged on wall 12b, as well as capacitive sensor 24c' arranged on wall 12c. Third zone 18 contains capacitive sensor 24c" arranged on wall 12c, as well as capacitive sensor 24d arranged on wall 12d. Each of capacitive sensors 24 includes pad 26, a first layer of conductive material 28a, dielectric material 30, and a second layer of conductive material 28b. Leads 32 are attached to each of the conductive material layers 28a and 28b of capacitive sensors 24.

Capacitive sensors 24 are arranged on walls 12. Each of capacitive sensors 24 is configured to detect a corona buildup in an adjacent zone. Capacitive sensors 24 detect displacement currents within adjacent zones. Detection of displacement currents are used to detect corona build-up in the zone adjacent to the capacitive sensor. Capacitive sensors 24 may cover a significant portion of walls 12. For example, in one embodiment, capacitive sensors 24 cover a majority of the surface area of walls 12 adjacent to each zone. Capacitive sensors 24 may be arranged on any of the walls of box 10. In alternative embodiments, more than one capacitive sensor 24 may be arranged on each of walls 12.

Corona events cause electrical current (i.e., displacement current) to flow between the plates formed by conductive materials 28a and 28b. The geometry and location of capacitive sensors 24 allows capacitive sensors 24 to detect displacement currents in zones 14, 16, and 18 adjacent to capacitive sensors 24. Corona buildup has a known frequency signature that can be measured to detect a corona buildup. Controller 22 measures the voltage across capacitive sensors 24, and based on the frequencies measured can determine when a corona buildup is occurring. In response to a detected corona event, controller 22 may undertake remedial actions, such as reducing power distribution to electrical components of the affected zone 12.

In addition to corona events, which are precursors to an arc event, controller 22 also monitors for arc fault events. For example, in the embodiment shown in Fig. 1, fiber optic cables 34 are positioned to route light signals from first zone 14, second zone 16, and third zone 18, respectively, to controller 22, which includes a plurality of photodetectors 36. In the event of arcing, light is emitted which is detected by controller 22 via fiber optic cables 34. Because walls 12 separate each of the zones from one another, light caused by arcing within one zone will only be routed to controller 22 by fiber optic cable 34 attached to that particular zone. For example, in the event that capacitive sensors 24b" and 24c' indicate a corona event in second zone 16, controller 22 may reduce power distributed to second zone 16 via bus 20. If photodetector 36b then detects a flash of light in second zone 16 despite those initial remedial measures, controller 22 may disconnect all power to electrical components in second zone 16.

In alternative embodiments, varying numbers of capacitive sensors may be distributed in each zone (e.g., 14, 16, 18). In some embodiments, only one capacitive sensor 24 need by used, whereas in others a plurality of capacitive sensors 24 may be arranged in each zone. In alternative embodiments, the number of capacitive sensors 24 employed in each zone need not be the same. Additionally, the number of zones in alternative embodiments may vary based on the needs of the electrical box. Furthermore, there can be multiple photo-detectors and fiber optic cables or multiple fiber optic cables connected to single photo-detector in one zone. This will allow better detection and provide redundancy.

In one embodiment, additive manufacturing is used to build the layers of capacitive sensors 24. In one example, ultrasonic additive manufacturing is used to apply pad 26, a first layer of conductive material 28, dielectric material 30, and a second layer of conductive material 28. In this way, two capacitive plates are built up of the conductive material 28 with a dielectric material 30 in between them, electrically isolated from box 10 and walls 12 by pad 26.

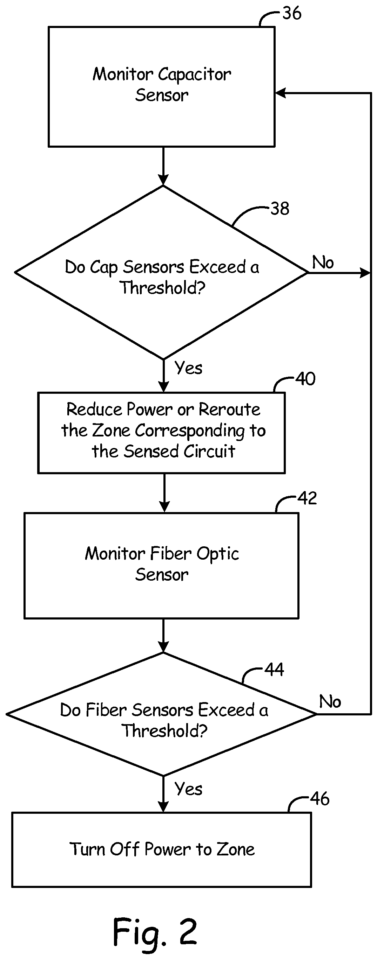

Fig. 2 is a flow chart illustrating steps performed by controller 22 in detecting and responding to corona events. Continued reference is made to elements described with respect to Fig. 1.

At step 36, controller 22 monitors capacitive sensors 24 to detect the presence of displacement currents indicative of a corona event. As previously described, displacement current can be used to identify corona events by current amplitudes and frequencies that are unique to such phenomena.

At step 38, controller 22 determines whether the current at the capacitive sensors indicate a corona event. The output of sensors 24 is measured against a reference voltage, current, and frequency, to determine whether a corona event has occurred. If the current at the capacitive sensors does not exceed the threshold in a specific frequency pattern, monitoring of the sensors continues as described with respect to step 38.

If the measured current of step 38 exceeds the threshold, then at step 40, controller 22 reduces or reroutes power to the zone in which the corona event was detected. Often, the controller is configured to measure current flow of several capacitive sensors within each of several zones. Power can be reduced to only those zones for which measured capacitor current at step 38 exceeds such a threshold.

At step 42, controller 22 receives optical data from a photodetector 36 attached to a fiber optic cable. Optical data may be provided contemporaneously with monitored capacitive data, or may be monitored only in response to a detected corona event. In the event of arcing, light can be routed from the affected zone via fiber optic cable 34 to photodetector 36.

At step 44, data received from photodetector 36 is analyzed to determine whether the optical signal is greater than a threshold. If, after power reduction at step 40, the optical sensor data does not exceed the threshold, then an arc has likely not occurred. In that event, capacitor sensor current may continue to be monitored at step 36.

At step 46, if the optical signal is greater than a threshold, an arc has likely occurred and the affected zone is disconnected from power. As with corona/capacitive current, the controller can turn off power to only a zone in which the optical data exceeded a threshold.

In an alternative embodiment, the photodetection and capacitive sensing may be used in parallel, rather than sequentially. For example, if the capacitor detection fails, the photo detection will still work, thus providing a more redundant detection system.

While the invention has been described with reference to an exemplary embodiment, it will be understood by those skilled in the art that various changes may be made and equivalents may be substituted for elements thereof without departing from the scope of the invention which is defined by the appended claims.

## Claims

1. A power distribution cabinet (10) comprising:
a housing having a plurality of walls (12a,12b,12c) that define a plurality of zones (14,16,18) for housing electric components;
and **characterised by** further comprising:
a capacitive sensor (24) located on an interior surface of each of the plurality of walls (12a,12b,12c), each capacitive sensor (24) including a first conductive layer (28b) located proximate to the interior surface of the wall (12), a second conductive layer (28a) located distal from the interior surface of the wall (12), and a dielectric layer (30) located between the first and second conductive layers (28b,28a);
first and second output terminals (32) connected to the first and second conductive layers (28b,28a) of each of the capacitive sensors (24) to provide an output representative of displacement current within the power distribution cabinet (10); and
a photodetector (36) for each of the plurality of zones (14,16,18) configured to receive optical data indicative of an arc fault.

2. The power distribution cabinet of claim 1, wherein at least two capacitive sensors (24) are arranged within each of the plurality of zones (14,16,18).

3. The power distribution cabinet of claim 1 or 2, and further comprising a controller (22) configured to receive the output provided via each of the first and second output terminals (32), and to selectively control power supplied to the electric components housed within the plurality of zones (14,16,18).

4. The power distribution cabinet of claim 3, wherein the controller (22) is configured to reduce power to the electric components within one of the plurality of zones (14,16,18) in the event that displacement current sensed by one of the capacitive sensors (24) associated with the particular zone (14,16,18) exceeds a threshold.

5. The power distribution cabinet of any preceding claim, and further comprising a fiber optic cable (34) that couples the respective zone (14,16,18) and the photodetector (36) for that zone.

6. The power distribution cabinet of any preceding claim, wherein each capacitive sensor (24) comprises a stack of layers that are welded together ultrasonically.

7. A method of preventing electrical discharge in the power distribution cabinet of any preceding claim, the method comprising:
sensing a displacement current in a capacitive sensor (24) located in a zone (14, 16, 18), wherein the displacement current is indicative of a corona buildup;
reducing power distributed to an electrical component within the zone (14,16,18) if the output representative of the displacement current in the zone (14,16,18) is greater than a threshold;
sensing optical data at a photodetector (36), wherein the optical data is indicative of an arc fault; and
turning off power to an electrical component within a zone (14,16,18) if the optical signal is greater than a threshold.

## Patentansprüche

1. Stromverteilerkasten (10), der Folgendes umfasst:
ein Gehäuse mit einer Vielzahl von Wänden (12a, 12b, 12c), die eine Vielzahl von Bereichen (14, 16, 18) zur Aufnahme elektronischer Komponenten definiert;
und **dadurch gekennzeichnet, dass** ferner Folgendes umfasst ist:
eine kapazitiver Sensor (24), der sich an einer Innenfläche jeder der Vielzahl von Wänden (12a, 12b, 12c) befindet, wobei jeder kapazitive Sensor (24) eine erste leitende Schicht (28b), die sich nahe der Innenfläche der Wand (12) befindet, eine zweite leitende Schicht(28a), die sich distal von der Innenfläche der Wand (12) befindet, und eine dielektrische Schicht (30) beinhaltet, die sich zwischen der ersten und der zweiten leitenden Schicht (28b, 28a) befindet;
ein erster und ein zweiter Ausgangsanschluss (32), die mit der ersten und der zweiten leitenden Schicht (28b, 28a) jedes der kapazitiven Sensoren (24) verbunden sind, um ein Ausgangssignal des Verschiebungsstroms innerhalb des Stromverteilerkastens (10) bereitzustellen; und
einen Photodetektor (36) für jeden der Vielzahl von Bereichen (14, 16, 18), der konfiguriert ist, um optische Daten zu empfangen, die auf einen Lichtbogenfehler hinweisen.

2. Stromverteilerkasten nach Anspruch 1, wobei mindestens zwei kapazitive Sensoren (24) innerhalb jedes der Vielzahl von Bereichen (14, 16, 18) angeordnet sind.

3. Stromverteilerkasten nach Anspruch 1 oder 2, und wobei ferner eine Steuerung (22) umfasst ist, die konfiguriert ist, um die Ausgabe zu empfangen, die über jeden des ersten und des zweiten Ausgangsanschlusses (32) bereitgestellt wird, und um selektiv den Strom zu steuern, der den elektronischen Komponenten zugeführt wird, die innerhalb der Vielzahl von Bereichen (14, 16, 18) aufgenommen sind.

4. Stromverteilerkasten nach Anspruch 3, wobei die Steuerung (22) konfiguriert ist, um den Strom an die elektronischen Komponenten innerhalb eines der Vielzahl von Bereichen (14, 16, 18) zu reduzieren, in dem Fall, dass Verschiebungsstrom, der durch einen der kapazitiven Sensoren (24) erfasst wird, die dem bestimmten Bereich (14, 16, 18) zugewiesen sind, einen Schwellenwert überschreitet.

5. Stromverteilerkasten nach einem der vorhergehenden Ansprüche, und wobei ferner ein Glasfaserkabel (34) umfasst ist, das den entsprechenden Bereich (14, 16, 18) an den Photodetektor (36) für diesen Bereich koppelt.

6. Stromverteilerkasten nach einem der vorhergehenden Ansprüche, wobei jeder kapazitive Sensor (24) einen Stapel Schichten umfasst, die miteinander ultraschallverschweißt sind.

7. Verfahren zum Verhindern elektrischer Entladung in dem Stromverteilerkasten nach einem der vorhergehenden Ansprüche, wobei das Verfahren Folgendes umfasst:
Erfassen eines Verschiebungsstroms in einem kapazitiven Sensor (24), der sich in einem Bereich (14, 16, 18) befindet, wobei der Verschiebungsstrom auf einen Koronaaufbau hinweist;
Reduzierung des Stroms, der an eine elektronische Komponente innerhalb des Bereichs (14, 16, 18) verteilt wird, falls das Ausgangssignal des Verschiebungsstroms in dem Bereich (14, 16, 18) größer als ein Schwellenwert ist.
Erfassen optischer Daten an einem Photodetektor (36), wobei die optischen Daten auf einen Lichtbogenfehler hindeuten; und Abschalten des Stroms an eine elektronische Komponente innerhalb des Bereiches (14, 16, 18), falls das optische Signal größer als ein Schwellenwert ist.

## Revendications

1. Armoire de distribution électrique (10) comprenant :
un boîtier ayant une pluralité de parois (12a, 12b, 12c) qui définissent une pluralité de zones (14, 16, 18) pour loger des composants électriques ;
et **caractérisée en ce qu'**elle comprend en outre :
un capteur capacitif (24) situé sur une surface intérieure de chacune de la pluralité de parois (12a, 12b, 12c), chaque capteur capacitif (24) incluant une première couche conductrice (28b) située à proximité de la surface intérieure de la paroi (12), une seconde couche conductrice (28a) située à une position distale de la surface intérieure de la paroi (12), et une couche diélectrique (30) située entre les première et seconde couches conductrices (28b, 28a) ;
de première et seconde bornes de sortie (32) connectées aux première et seconde couches conductrices (28b, 28a) de chacun des capteurs capacitifs (24) pour fournir une puissance représentative du courant de déplacement dans l'armoire de distribution électrique (10) ; et
un photodétecteur (36) pour chacune de la pluralité de zones (14, 16, 18) configuré pour recevoir des données optiques révélatrices d'un défaut d'arc.

2. Armoire de distribution électrique selon la revendication 1, dans laquelle au moins deux capteurs capacitifs (24) sont agencés dans chacune de la pluralité de zones (14, 16, 18).

3. Armoire de distribution électrique selon la revendication 1 ou 2, et comprenant en outre un dispositif de commande (22) configuré pour recevoir la puissance fournie au moyen de chacune des première et seconde bornes de sortie (32), et pour commander de manière sélective l'énergie envoyée aux composants électriques logés dans la pluralité de zones (14, 16, 18) .

4. Armoire de distribution électrique selon la revendication 3, dans laquelle le dispositif de commande (22) est configuré pour réduire l'énergie fournie aux composants électriques dans l'une de la pluralité de zones (14, 16, 18) au cas où le courant de déplacement détecté par l'un des capteurs capacitifs (24) associés à la zone (14, 16, 18) particulière dépasse un seuil.

5. Armoire de distribution électrique selon une quelconque revendication précédente, et comprenant en outre un câble à fibres optiques (34) qui couple la zone (14, 16, 18) respective et le photodétecteur (36) pour cette zone.

6. Armoire de distribution électrique selon une quelconque revendication précédente, dans laquelle chaque capteur capacitif (24) comprend une pile de couches qui sont soudées ensemble par ultrasons.

7. Procédé de prévention de décharge électrique dans l'armoire de distribution électrique selon une quelconque revendication précédente, le procédé comprenant :
la détection d'un courant de déplacement dans un capteur capacitif (24) situé dans une zone (14, 16, 18), dans lequel le courant de déplacement est révélateur d'une accumulation d'effet de couronne ;
la réduction de l'énergie distribuée à un composant électrique dans la zone (14, 16, 18) si la puissance représentative du courant de déplacement dans la zone (14, 16, 18) est supérieure à un seuil ;
la détection de données optiques au niveau d'un photodétecteur (36), dans lequel les données optiques sont révélatrices d'un défaut d'arc ; et
la mise hors tension d'un composant électrique dans une zone (14, 16, 18) si le signal optique est supérieur à un seuil.
